# EUROPEAN PATENT SPECIFICATION

(11) **EP 0 415 336 B1**
(45) Date of publication and mention of the grant of the patent: **27.04.1994**
(21) Application number: 90116440.0
(22) Date of filing: 28.08.1990
(51) Int. Cl.: H05K 3/02, H05K 3/28, H05K 3/46

(54) **Method for manufacturing thick film circuit substrate**
Verfahren zur Herstellung eines Substrates für Dickschichtschaltkreise
Procédé de fabrication d'un substrat pour circuit à couche épaisse

(30) Priority: 31.08.1989 JP 226284/89
(43) Date of publication of application: 06.03.1991
(73) Proprietor: MATSUSHITA ELECTRIC INDUSTRIAL CO., LTD., Kadoma-shi, Osaka-fu, 571 (JP)
(72) Inventor: Kumagai, Koichi, Ikoma-shi, Nara-ken (JP); Onishi, Hiroaki, Higashiosaka-shi, Osaka-fu (JP)
(74) Representative: Eisenführ, Speiser & Partner

(56) References cited:
- PATENT ABSTRACTS OF JAPAN vol. 13, no. 396 (E-815)4 September 1989; JP-A-01140695
- PATENT ABSTRACTS OF JAPAN vol. 11, no. 88 (E-490)18 March 1987;& JP-A-61240667
- PATENT ABSTRACTS OF JAPAN vol. 11, no. 23 (E-473)22 January 1987;& JP-A-61194759
- PATENT ABSTRACTS OF JAPAN vol. 13, no. 444 (E-828)5 October 1989;& JP-A-01170038
- PATENT ABSTRACTS OF JAPAN vol. 8, no. 103 (E-244)15 May 1984;& JP-A-59018669
- PATENT ABSTRACTS OF JAPAN vol. 10, no. 233 (E-427)13 August 1986;& JP-A-61065464
- PATENT ABSTRACTS OF JAPAN vol. 12, no. 77 (E-589)10 March 1988;& JP-A-62216259

## Description

### BACKGROUND OF THE INVENTION

The present invention relates to a method for manufacturing a thick film circuit substrate.

For miniaturization and high reliability of electronic equipment products, a thick film circuit substrate manufactured by baking a thick film circuit on a ceramic substrate has been especially noted.

A screen printing method is normally used as the method for manufacturing the thick film circuit substrate. In the method, photosensitive resin is coated onto a metal or plastic mesh, a light beam is irradiated on the resin through a photomask with a specified pattern for exposure, the exposed resin is developed, and then a printing screen with a specified pattern is previously made in this way. Then, thick film-forming paste of either insulating material such as glass or conductor such as Ag/Pd or Cu is coated onto a ceramic substrate through the screen by a printing to form a specified thick film-forming paste pattern thereon. The paste, as an e ample of a conductor, is comprised of metallic grain such as Ag/Pd or Cu, vehicle as organic substance, metallic and inorganic additional matter for improvement of properties, and organic diluent for viscosity modification. Thereafter, the paste is dried at 100-180 °C and baked at about 800-1,000 °C.

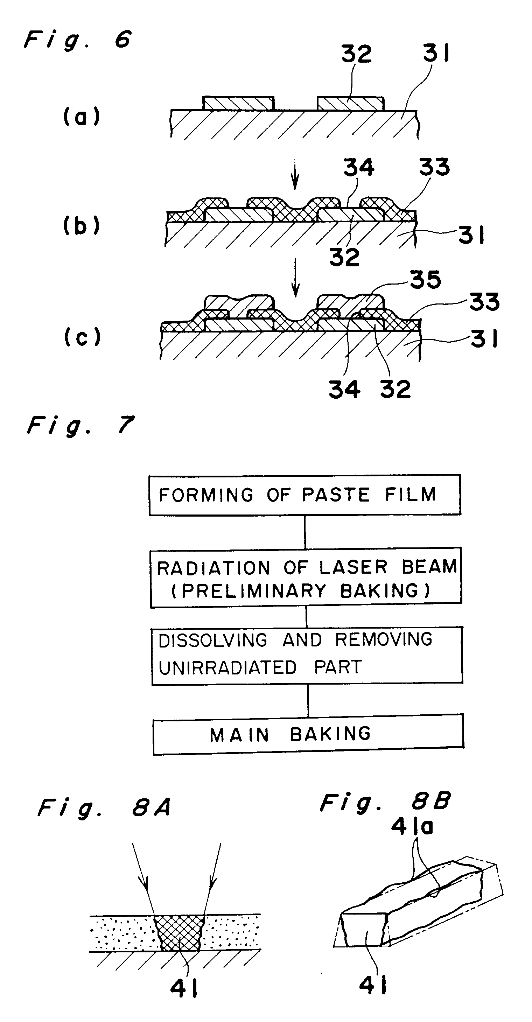

Fig. 6 shows a case where a substrate is multilayered to form a high density circuit substrate. In this case, after a conductor thick film-forming paste is printed, dried, and baked on a substrate 31 to form a film 32 with a circuit pattern, thick film-forming insulating paste is printed, dried, and baked on the substrate 31 through a screen with a specified pattern for forming through holes to form an insulating film 33 having through holes 34, and furthermore another film 35 with a circuit pattern is formed on the insulating film 33 similarly to the above process for the film 32. The above-described processes are repeated to form the multilayer circuit substrate.

However, it is necessary to prepare a screen each circuit pattern and to form a photomask with a pattern equal to a desired pattern in forming the screen. Therefore, a new photomask must be formed in accordance with modification and change of the pattern, resulting in increasing the manufacturing cost. Additionally, the use of the screen prevents from sufficiently reducing the line width of the circuit pattern, resulting in difficulty of high density wiring. In other words, from the viewpoint of the thickness of necessary conductor and insulating material and repetition life of the screen, an about 150-300 mesh screen is employed at the present time. In this case, each limited value of the line width and the distance between the adjacent lines of the circuit in quality production is about 0.15mm.

In the multilayer circuit substrate, it is difficult to form a minute through hole with the diameter of 0.3mm or less on the insulating film, resulting in preventing from having high density.

In order to solve such problems, methods for manufacturing thick film circuit substrates by laser beam machining are disclosed in Japanese Patent Publication No. 59-29160 and Japanese Laid-open Patent Publication No. 61-290796. In each method, as shown in Fig. 7, a thick film-forming paste is coated onto a substrate, a laser beam is irradiated on the paste in accordance with a pattern corresponding to a circuit pattern for preliminarily baking, thereafter the unirradiated part of the paste is dissolved on and removed from the substrate to form a film with a specified pattern, and the substrate is subject to main baking in a kiln.

In the multilayer circuit substrate, after the film with the circuit pattern is formed as described above, a thick film-forming insulating paste is coated onto the film with the circuit pattern, baked in a kiln, and thereafter through holes are formed at the substrate by irradiation of laser beam.

Another method for manufacturing a thick film circuit substrate is disclosed in Japanese Laid-open Patent Publication No. 61-194759. In the method, after a thick film-forming paste is coated onto, dried, and baked a substance, a laser beam is irradiated on the substrate to remove a laser beam-irradiated part of the baked film therefrom so as to form a film with a specified circuit pattern.

In the method disclosed in Japanese Patent Publication No. 59-29160, it is necessary to dissolve on and remove the laser beam-unirradiated part of the paste from the substrate and to arrange waste disposal equipments for solution of the dissolution, resulting in increase of the manufacturing cost. Additionally, when a laser beam is irradiated on the surface of the substrate to preliminarily bake the film on the substrate by heat conduction along a film thickness direction, as shown in Figs. 8A and 8B, the cross-sectional shape of the preliminarily baked section 41 of the film is inverted trapezoid contrary to ideal trapezoid shown by imaginary lines in Fig. 8B, that is, non-convergent configuration, and besides, the side edges 41a of the line of the preliminarily baked section 41 of the film along a scanning direction of the laser beam have poor linearity. Furthermore, in a thick film substrate, it is necessary to heat the substrate so that the lower layer of the films on the substrate is held at a specified temperature while preventing the evaporation of the upper layer of the films on the substrate. Therefore, the manufacturing process is forced to lower output and lower speed machining, so that a thicker film cannot be formed on the substrate and then the limited value of the film thickness is about 20µm.

Moreover, in the multilayer circuit substrate, since the laser beam machining is performed after baking so as to form minute through holes at the insulating film, it takes long time to do the machining.

In the method disclosed in Japanese Laid-open Patent Publication No. 61-194759, since the part except for the part forming a desired pattern is removed by the irradiation of the laser beam after baking the paste, it is necessary to have extremely large energy for the removal, resulting in poor productivity and poor energy efficiency.

### SUMMARY OF THE INVENTION

Accordingly, an essential object of the present invention is to provide a method for manufacturing a thick film circuit substrate to resolve the disadvantages and capable of manufacturing the thick film circuit substrate with high density at lower cost, improved productivity, and improved electrical characteristics, and improving accuracy of a wiring line of a circuit.

Another important object of the present invention is to provide a method for manufacturing a thick film circuit substrate capable of efficiently forming minute through holes at the substrate with high density wiring.

In accomplishing these and other objects, there are provided three methods for manufacturing a thick film circuit substrate, as defined in claims 1, 5 and 6, respectively.

According to one aspect of the present invention, there is provided a method for manufacturing a thick film circuit substrate, comprising the steps of: coating paste onto a substrate to form a thick paste film; drying the paste film on the substrate; irradiating a laser beam on the dried paste film to remove the paste film in an area, where the laser beam is irradiated, to form a film with a specified pattern; and baking the film with the pattern.

By the above construction of the aspect of the present invention, the paste film formed by coating the paste onto the substrate is dried before the laser beam is irradiated on the paste film, the laser beam-irradiated part of the paste film is evaporated and removed from the substrate to form the film with the pattern and bake the film. Therefore, it is possible to form a film with a minute pattern without a photomask, and it is unnecessary to perform the process for dissolving and removing the paste film and arrange the waste disposal equipments. Furthermore, the irradiated part of the dried paste film is evaporated and removed from the substrate to form a film having a convergent cross-sectional shape of a wiring line of a desired pattern and side edges of the line with good linearity, resulting in a thick film circuit with improved electrical characteristics with respect to noise, insulating properties, and impedance. Additionally, it is possible to perform a high speed machining by a high output laser even though the film has large thickness. Therefore, a thick film circuit having a pattern with large width of the line of wiring and reduced wiring resistance can be manufactured at good productivity. Moreover, a thick paste film can be formed in a specified pattern onto a substrate and the necessary part of the paste film is processed by a laser beam, so that the laser beam machining and the printing can be combined with each other.

When the laser beam machining is performed onto the paste film in a semi-dried state, the process can have good workability, good linearity of the side edges of the pattern, and improved adhesive force applied between the paste film and the substrate.

When dust produced in the laser beam irradiating process is blown away or sucked to remove from the substrate or etching is slightly performed after baking, it is possible to prevent insulating properties from worsening by dust attached between the lines of the wiring, resulting in a circuit substrate with high insulating properties.

According to another aspect of the present invention, there is provided a method for manufacturing a thick film circuit substrate, comprising the steps of: forming a baked film with a circuit pattern on a substrate; coating insulating paste onto the film and a surface of the substrate to form a thick insulating paste film; drying the coated paste film; irradiating a laser beam at a specified position of the dried insulating paste film to form a through hole; and baking the paste film.

According to another aspect of the present invention, there is provided a method for manufacturing a thick film circuit substrate, comprising the steps of: coating thick conductor paste onto a substrate to form a conductor paste film; drying the paste film; irradiating a laser beam on the dried paste film to remove a part of the paste film, where the laser beam is irradiated, to form a film with a circuit pattern; baking the film with the circuit pattern; coating insulating paste onto the baked film with the circuit pattern and a surface of the substrate to form a thick insulating paste film; drying the coated insulating paste film; irradiating a laser beam at a specified position of the dried insulating paste film to form a through hole; and baking the dried insulating paste film having the through hole.

By the above construction of the aspects of the present invention, in the multilayer circuit substrate in which an insulating film is arranged between films each of which has a circuit pattern, the laser beam is irradiated on the insulating paste film in a dry state to form a through hole at the insulating film, so that a minute through hole with about 0.05-0.1mm diameter can be efficiently formed at the film, resulting in a multilayer wiring substrate with high density.

### BRIEF DESCRIPTION OF THE DRAWINGS

These and other objects and features of the present invention will become clear from the following description taken in conjunction with the preferred embodiments thereof with reference to the accompanying drawings, in which:
Fig. 1 is an explanatory view showing a manufacturing process of a thick film circuit substrate according to a first embodiment of the present invention;
Fig. 2 is a flow chart of the process;
Figs. 3A and 3B are, respectively, perspective views showing a substrate to which dust is attached in irradiating a laser beam and the substrate from which dust is removed;
Fig. 4 is an explanatory view showing a manufacturing process of a thick film circuit substrate according to a second embodiment of the present invention;
Fig. 5 is a flow chart of the process;
Fig. 6 is an explanatory view showing a manufacturing process of a multilayered thick film circuit substrate in a known screen printing method;
Fig. 7 is a flow chart of a manufacturing process of a thick film circuit substrate in a known laser beam machining method;
Fig. 8A is a cross-sectional view showing a heating state in baking in accordance with irradiation of laser beam; and
Fig. 8B is a perspective view of a formed circuit pattern.

### DETAILED DESCRIPTION OF THE EMBODIMENTS

Before the description of the present invention proceeds, it is to be noted that like parts are designated by like reference numerals throughout the accompanying drawings.

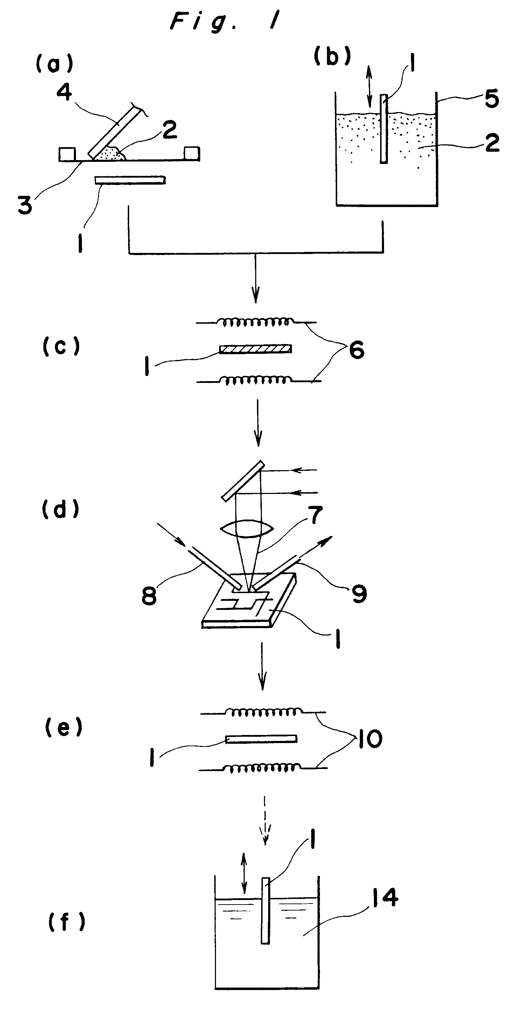

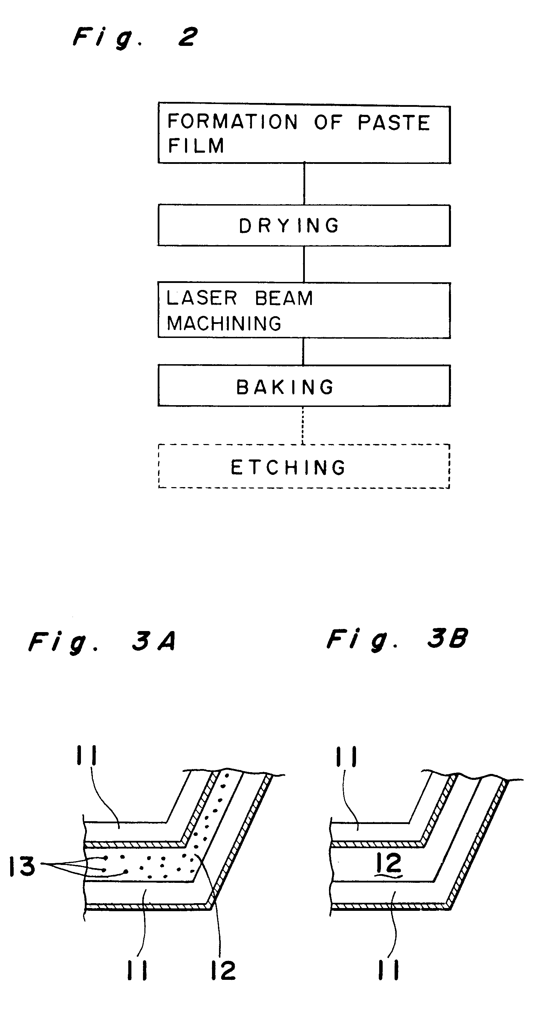

In Figs. 1 and 2 showing a first embodiment of the present invention, firstly, thick film-forming paste 2 is coated onto a ceramic substrate 1 to form a thick paste film. A screen printing method shown in the process (a) of Fig. 1 or a dipping method shown in the process (b) of Fig. 1 can be used as the coating method. In the process (a), referring numeral 3 denotes a screen, and 4 a squeegee. In the process (b), referring numeral 5 denotes a paste tank.

As shown in the process (c) of Fig. 1, the substrate 1 is inserted in a drying furnace 6 to heat and dry it at about 70°C for 5 to 30 minutes or at 150°C for 2-15 minutes. In the drying process, the weight of the solvent in the paste film after drying is 2-50% of the weight of the solvent in the paste film before drying, preferably.

Next, as shown in the process (d) of Fig. 1, a laser beam 7 is irradiated on the dried paste film on the substrate 1 in accordance with a desired pattern to heat, evaporate, and remove the laser beam-irradiated part of the paste film from the substrate 1 so as to form a film with a pattern film. A yag laser, a CO₂ laser, an excimer laser, or a laser employing a second harmonic component of a yag laser can be used as a laser for outputting the laser beam 7. A dried paste film with 10-35µm film thickness can be processed at 5-200mm/sec. speed by such a laser with 1-10 KHz laser repetition frequency and 0.5-10W output. A film with a minute pattern in which the line width of wiring is 20-50µm can be formed by the process.

At this time, dust produced in the process (d) is blown away by blowing off air or inert gas through a blow-off nozzle 8 towards the irradiated part of the film or the dust is sucked and removed therefrom with a suction nozzle 9. Then, such an operation can prevent the dust 13 from attaching to a part 12 on the substrate 1 where the paste film positioned between adjacent lines 11 of the pattern is removed by the laser beam therefrom as shown in Fig. 3A, so that the pattern with high insulating properties without any dust 13 between the adjacent lines 11 thereof can be obtained as shown in Fig. 3B.

Next, as shown in the process (e) of Fig. 1, the substrate 1 at which the pattern film is formed is inserted in a kiln 10 to bake at 600-900°C.

Thereafter, as shown in the process (f) of Fig. 1, after the substrate 1 is dipped in an etching solution 14 to slightly etch, the substrate 1 is washed to certainly remove the dust 13 left between the lines 11 of the pattern from the substrate 1 so as to obtain the pattern with high insulating properties.

When the dust 13 is blown away or sucked in irradiating the laser beam, the etching process can be omitted. Conversely, when the etching process is performed, the blowing or suction process can be omitted. When the etching process and the blowing or suction process are performed, it is possible to more certainly prevent the dust 13 from attaching to the substrate 1.

In the above description, though it does not refer to the kinds of the thick film-forming paste, a film with a conductor circuit pattern, an insulating film, and a resistance element, each of which has a desired pattern, can be formed by using thick film-forming conductor paste such as Ag/Pd or Cu, thick film-forming insulating paste such as glass, and various thick film-forming paste for a resistance element, respectively.

For example, thick film-forming conductor paste (paste Nos. 9153 and 6001 which characteristics are shown in the catalogue, which title is "Du Pont thick film conductor compositions", of E.I. du Pont de Nemours and Co.) is coated onto an alumina substrate with 96% purity by using a stainless screen with 250 mesh and 10µm emulsion thickness and dried at 90°C for 10 minutes to obtain a dried conductor paste film with about 20µm film thickness.

A laser beam with 3KHz laser repetition frequency and 1.5W output is irradiated moving at 20-30mm/sec. speed on the paste of the catalogue No. 9153 while blowing air through a blow-off nozzle to form a film having a minute conductor pattern with 20-50µm of both the line width and the distance between the lines of the pattern. Thereafter, the substrate is baked in a N₂ continuous kiln at 900°C for 10 minutes to form a baked film having a pattern with small line width and good insulating properties and continuity.

A laser beam with 3KHz laser repetition frequency and 1W output is irradiated moving at 20-30mm/sec. speed on the paste of the catalogue No. 6001 while blowing air through a blow-off nozzle to form a film having a minute conductor pattern with 20-50µm of both the line width and the distance between the adjacent lines of the pattern. Thereafter, the substrate is baked in a N₂ continuous kiln at 600°C for 5 minutes to form a baked film having a pattern with small line width and good insulating properties and continuity.

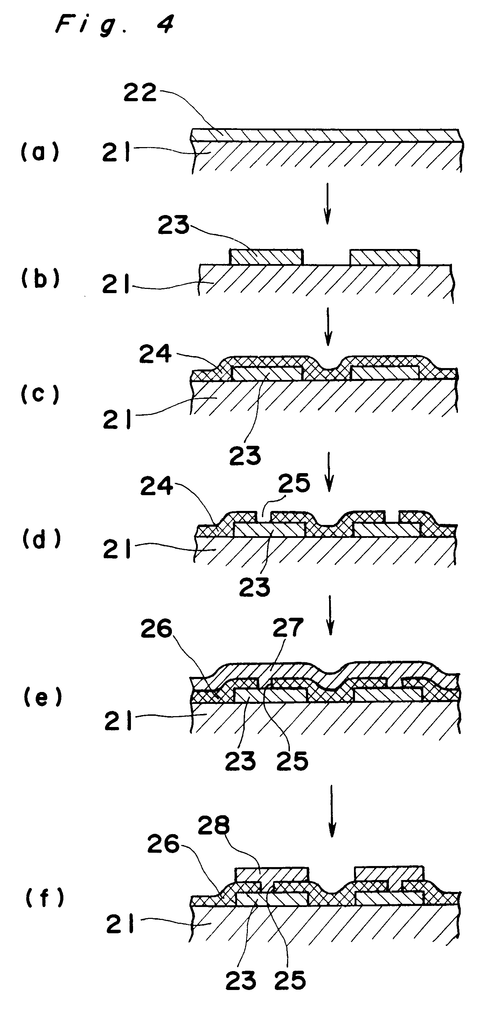

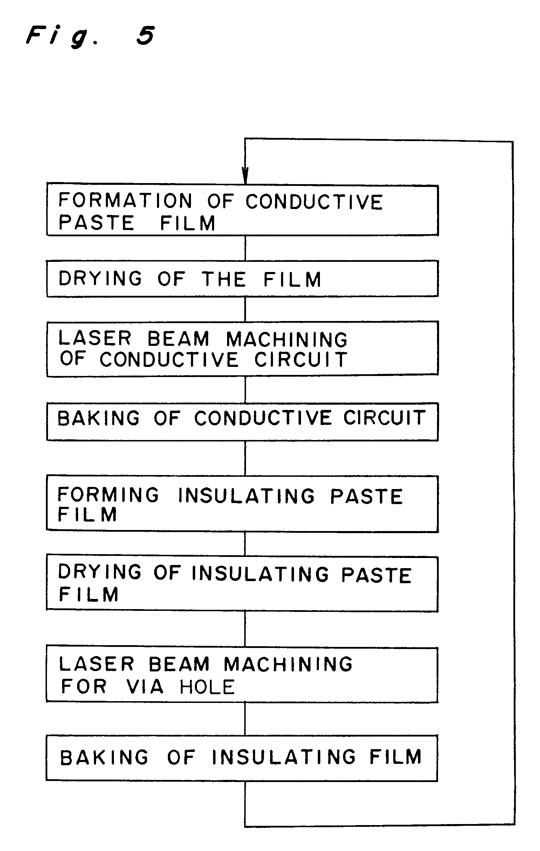

Next, a second embodiment of the present invention applicable to the manufacturing of a multilayer thick film circuit substrate will be described hereinafter referring to Figs. 4 and 5.

Firstly, as shown in the process (a) of Fig. 4, thick film-forming conductor paste is coated onto a substrate 21 to form a conductor paste film 22. After the paste film 22 is dried and then a laser beam is irradiated on the paste film 22 in the process (b) of Fig. 4 to form a first film 23 with a first conductor circuit pattern, the first film 23 is baked. The above processes (a) and (b) are similar to those of the first embodiment.

Next, in the process (c) of Fig. 4, thick film-forming insulating paste is coated onto the first film 23 with the first conductor circuit pattern and the substrate 21 to form a thick insulating paste film 24 and then the insulating paste film 24 is dried. Next, in the process (d) of Fig. 4, a laser beam is irradiated at a specified position of the dried insulating paste film 24 to form through holes 25 generally called as via holes. Minute through holes 25 with 0.05-0.1mm diameter can be formed on the insulating paste film 24 by the laser beam machining, and the through hole-forming process can be efficiently performed because the through holes 25 are formed on the non-baked insulating paste film 24. After the formation of the through holes 25, the insulating paste film 24 is baked to form an insulating film 26.

Next, in order to form a second film 28 with a second conductor circuit pattern, as shown in the process (e) of Fig. 4, thick film-forming conductor paste is coated onto the insulating film 26 to form a second conductor paste film 27. At this time, the conductor paste enters the through holes 25 to electrically contact with the first film 23 with the first conductor circuit pattern previously formed. Thereafter, the second conductor paste film 27 is dried. Then, in the process (f) of Fig. 4, a laser beam is irradiated on the baked second conductor paste film 27 to form the second film 28 with the second conductor circuit pattern by the laser beam machining, and then the second film 28 is baked. The above processes (e)-(f) are similar to those of the first embodiment.

Thereafter, by repeating the processes (c)-(f), a multilayer circuit substrate having three or more films with conductor circuit patterns can be manufactured.

Although the second embodiment is described, as an example, that the coating, drying, laser beam machining, and baking processes of the conductor paste film are performed in forming the film with the conductor circuit pattern similarly to those of the first embodiment, other process such as a screen printing process can be performed instead of the process for forming the film with the conductor circuit pattern.

According to the embodiments, the following advantages can be obtained.

The laser beam is irradiated on the paste after drying the thick film paste, the laser beam-irradiated part of the paste film is evaporated and removed from the substrate to the film with a desired pattern, and the film with the desired pattern is baked. Therefore, it is possible to form minute wiring on the substrate without any photomask, and it is unnecessary to perform a process for dissolving and removing the paste from the substrate and to arrange waste disposal equipments. Furthermore, since the laser beam-irradiated part of the paste is evaporated and removed from the substrate, the cross-sectional shape of the line of the thick film pattern can be convergent configuration and the side edges of the line has good linearity. Then, a produced thick film circuit can have excellent electrically characteristics with respect to noise, insulating properties, and impedance. Since it is possible to perform the high speed machining by using a high output laser even though a produced film has large thickness, a thick film circuit with about 20-40µm thickness and a film having large width of the line of a circuit pattern and lower wiring resistance can be formed at good productivity. A thick film-forming paste can be formed in a specified pattern on a substrate and a necessary part of the film paste is processed by the laser beam, so that the printing and the laser beam machining processes can be combined with each other to form a thick film circuit substrate.

The laser beam machining process is performed with respect to the paste in a semi-dried state and therefore the processability can be improved, resulting in excellent linearity of the side edges of the line of the circuit pattern and improved adhesive force to the substrate.

Since dust produced in irradiating the laser beam is blown away or sucked for removal or the dust is removed from the substrate by slightly etching after baking, it is possible to prevent the insulating properties from worsening by the dust attached between the adjacent lines of the wiring, so that a circuit substrate with high insulating properties can be produced.

In a multilayer circuit substrate in which an insulating film is put between the films each of which has a circuit pattern, the through holes are formed at the insulating film in a dry state by irradiating the laser beam, so that minute through holes can be efficiently formed at the insulating film and a multilayer wiring substrate with high density can be produced.

Although the present invention has been fully described in connection with the preferred embodiments thereof with reference to the accompanying drawings, it is to be noted that various changes and modifications are apparent to those skilled in the art.

## Claims

1. A method for manufacturing a thick film circuit substrate, comprising the steps of:
coating paste (2) onto a substrate (1) to form a thick paste film;
drying the paste film on the substrate (1);
irradiating a laser beam (7) on the dried paste film to remove the paste film in an area, where the laser beam (7) is irradiated, to form a film with a specified pattern; and
baking the film with the pattern.

2. The method for manufacturing a thick film circuit substrate as claimed in claim 1, wherein in the drying step, the paste film is dried so that weight of solvent in the paste film after drying is 2 to 50 percents of weight of solvent in the paste film before drying.

3. The method for manufacturing a thick film circuit substrate as claimed in claim 1, wherein in the irradiating step, dust produced in irradiating the laser beam (7) is removed by blowing away or suction.

4. The method for manufacturing a thick film circuit substrate as claimed in claim 1, further comprising the step of etching of the baked film, the step being performed after the baking step.

5. A method for manufacturing a thick film circuit substrate, comprising the steps of:
forming a baked film (23) with a circuit pattern on a substrate (21);
coating insulating paste onto the film (23) and a surface of the substrate (21) to form a thick insulating paste film (24);
drying the coated paste film (24);
irradiating a laser beam at a specified position of the dried insulating paste film (24) to form a through hole (25); and
baking the paste film (24).

6. A method for manufacturing a thick film circuit substrate, comprising the steps of:
coating thick conductor paste onto a substrate (21) to form a conductor paste film (22);
drying the paste film (22);
irradiating a laser beam on the dried paste film (22) to remove a part of the paste film (22), where the laser beam is irradiated, to form a film (23) with a circuit pattern;
baking the film (23) with the circuit pattern;
coating insulating paste onto the baked film (23) with the circuit pattern and a surface of the substrate (21) to form a thick insulating paste film (24);
drying the coated insulating paste film (24);
irradiating a laser beam at a specified position of the dried insulating paste film (24) to form a through hole (25); and
baking the dried insulating paste film (24) having the through hole (25).

## Patentansprüche

1. Verfahren zur Herstellung eines Substrats für Dickschichtschaltkreise mit den Schritten, daß man
ein Substrat (1) zur Herstellung einer Dick-Pastenschicht mit einer Paste (2) beschichtet,
die Pastenschicht auf dem Substrat (1) trocknet,
die trockene Pastenschicht mit einem Laserstrahl (7) bestrahlt, um die Pastenschicht in einem vom Laserstrahl (7) bestrahlten Bereich zu entfernen, so daß eine Schicht mit einem bestimmten Schaltbild entsteht, und
die Schicht mit dem Schaltbild einbrennt.

2. Verfahren zur Herstellung eines Substrats für Dickschichtschaltkreise nach Anspruch 1, wobei man bei der Trocknung die Pastenschicht so trocknet, daß das Gewicht des Lösungsmittels in der Paste nach dem Trocknen 2 bis 50 Prozent des Lösungsmittelsgewichts vor dem Trocknen beträgt.

3. Verfahren zur Herstellung eines Substrats für Dickschichtschaltkreise nach Anspruch 1, wobei man den bei der Bestrahlung mit dem Laserstrahl (7) entstehenden Staub durch Wegblasen oder Absaugen entfernt.

4. Verfahren zur Herstellung eines Substrats für Dickschichtschaltkreise nach Anspruch 1 mit dem weiteren Schritt, daß man die eingebrannte Schicht ätzt, wobei man das Ätzen nach dem Einbrennen durchführt.

5. Verfahren zur Herstellung eines Substrats für Dickschichtschaltkreise mit den Schritten, daß man
auf einem Substrat (21) eine eingebrannte Schicht (23) mit einem Schaltbild herstellt,
die Schicht (23) und die Oberfläche des Substrats (21) zur Herstellung einer isolierenden Dick-Pastenschicht (24) mit einer Isolationspaste beschichtet,
den aufgebrachte Pastenschicht (24) trocknet,
an einer bestimmten Stelle der trockenen isolierenden Pastenschicht (24) mit einem Laserstrahl ein Durchgangsloch (25) herstellt, und
die Pastenschicht (24) einbrennt.

6. Verfahren zur Herstellung eines Substrats für Dickschichtschaltkreise mit den Schritten, daß man
ein Substrat (21) zur Herstellung eine Leiterpastenschicht (22) dick mit einer Leiterpaste beschichtet,
die Pastenschicht (22) trocknet,
die trockene Pastenschicht (22) mit einem Laserstrahl bestrahlt, um zur Bildung einer Schicht (23) mit einem Schaltbild dort einen Teil der Pastenschicht (22) zu entfernen, wo der Laserstrahl einstrahlt,
die Schicht (23) mit dem Schaltbild einbrennt,
die eingebrannte Schicht (23) mit dem Schaltbild und die Oberfläche des Substrats (21) zur Herstellung einer isolierenden Dick-Pastenschicht (24) mit einer Isolationspaste beschichtet, die aufgebrachte isolierende Pastenschicht (24) trocknet,
an einer bestimmten Stelle der trockenen isolierenden Pastenschicht (24) mit einem Laserstrahl ein Durchgangsloch (25) herstellt, und
die trockenen isolierende Pastenschicht (24) mit dem Durchgangsloch (25) einbrennt.

## Revendications

1. Procédé de fabrication d'un substrat de circuit à couches épaisses, comprenant les étapes :
de revêtement d'un substrat (1) avec une pâte (2) pour former une couche épaisse de pâte ;
de séchage de la couche de pâte sur le substrat (1) ;
d'irradiation avec un faisceau laser (7) de la couche de pâte séchée pour retirer la couche de pâte dans une certaine zone, qui est irradiée par le faisceau laser (7), pour former une couche avec un motif déterminé ; et,
de cuisson de la couche avec le motif.

2. Procédé de fabrication d'un substrat de circuit à couches épaisses selon la revendication 1, dans lequel dans l'étape de séchage, la couche de pâte est séchée de telle façon que le poids de solvant dans la couche de pâte après séchage soit de 2 à 50 pour cent du poids de solvant dans la couche de pâte avant séchage.

3. Procédé de fabrication d'un substrat de circuit à couches épaisses selon la revendication 1, dans lequel dans l'étape d'irradiation, la poussière produite lors de l'irradiation par le faisceau laser (7) est éliminée par soufflage ou par succion.

4. Procédé de fabrication d'un substrat d'un circuit à couches épaisses selon la revendication 1, comprenant en outre l'étape d'attaque de la couche cuite, l'étape étant effectuée après l'étape de cuisson.

5. Procédé de fabrication d'un substrat de circuit à couches épaisses, comprenant les étapes :
de formation sur un substrat (21) d'une couche cuite (23) avec un motif de circuit ;
de revêtement de la couche (23) et de la surface du substrat (21) avec une pâte isolante pour former une couche épaisse de pâte isolante (24) ;
de séchage de la couche de pâte (24) déposée ;
d'irradiation avec un faisceau laser d'une position déterminée de la couche de pâte isolante séchée (24) pour former un trou traversant (25) ; et,
de cuisson de la couche de pâte (24).

6. Procédé de fabrication d'un substrat de circuit à couches épaisses, comprenant les étapes :
d'étalement d'une pâte conductrice épaisse sur un substrat (21) pour former une couche de pâte conductrice (22) ;
de séchage de la couche de pâte (22) ;
d'irradiation avec un faisceau laser de la couche de pâte séchée (22) pour éliminer une partie de la couche de pâte (22), qui a été irradiée par le faisceau laser, pour former une couche (23) avec un motif de circuit ;
de cuisson de la couche (23) avec le motif de circuit ;
d'étalement d'une pâte isolante sur la couche cuite (23) avec le motif de circuit et sur la surface du substrat (21) pour former une couche épaisse de pâte isolante (24) ;
de séchage de la couche de pâte isolante étalée (24) ;
d'irradiation avec un faisceau laser d'une position déterminée de la couche de pâte isolante séchée (24) pour former un trou traversant (25) ; et,
de cuisson de la couche de pâte isolante séchée (24) comportant le trou traversant (25).
